# EUROPEAN PATENT APPLICATION

(11) **EP 4 512 592 A1**
(43) Date of publication of application: **26.02.2025**
(21) Application number: 23791588.9
(22) Date of filing: 20.03.2023
(51) Int. Cl.: B29C 33/22, B29C 43/04, B29C 43/32

(54) **RESIN MOLDING DEVICE, AND METHOD FOR MANUFACTURING RESIN MOLDED ARTICLE**

(30) Priority: 22.04.2022 JP 2022070980
(71) Applicant: Towa Corporation, Kyoto-shi, Kyoto 601-8105 (JP)
(72) Inventor: NAKAO, Satoshi, Kyoto-shi, Kyoto 601-8105 (JP); YASUI, Hayato, Kyoto-shi, Kyoto 601-8105 (JP)
(74) Representative: Müller Hoffmann & Partner
(86) International application number: PCT/JP2023/010914
(87) International publication number: WO 2023/203935

(57) **Abstract**

The present invention provides a resin molding apparatus that clamps a plurality of molding dies and that performs resin molding by, while synchronizing the clamping of the plurality of molding dies, absorbing variations in the thickness of the object-to-be-molded in each molding die, and includes a raising-and-lowering linking mechanism 8 that causes the raising and lowering of an intermediate plate 4 to occur together with the raising and lowering of a movable platen 3, the raising-and-lowering linking mechanism 8 comprising a pantograph mechanism 81 that extends and contracts due to the raising and lowering of the movable platen 3, and a coupling mechanism 82 that couples a cross link part 811 of the pantograph mechanism 81 and the intermediate plate 4; and the coupling mechanism 82 has a connecting member 821 connected to the cross link part 811; a coupling member 822 that couples the connecting member 821 to the intermediate plate 4; and an elastic member 823a, 823b interposed between the connecting member 821 and the coupling member 822.

## Description

### Technical Field

The present invention relates to a resin molding apparatus and a resin molded product manufacturing method.

### Background Art

Conventionally, as disclosed in Patent Document 1, in a manufacturing apparatus for manufacturing synthetic resin molded bodies that includes a fixed lower die, an upper die that can be raised and lowered above the lower die, and a frame that supports an intermediate die arranged between the lower die and the upper die, it has been considered to connect the upper die, intermediate die, and lower die with a pantograph mechanism so that molding of a molded body by the upper die and intermediate die and molding of a molded body by the intermediate die and lower die is carried out simultaneously.

### Prior Art Literature

### Patent Literature

[Patent Document 1] Japanese Utility Model Application Publication No. S63-161708

### Summary of Invention

### Problem to be Solved by the Invention

However, the above-mentioned manufacturing apparatus does not take into consideration variations in thickness between molded bodies that are resin-molded by the upper die and the intermediate die and molded bodies that are resin-molded by the intermediate die and the lower die. Moreover, when resin molding is performed on an object-to-be-molded such as a substrate, variations in the thickness of the object-to-be-molded can end up causing variations in the quality or the like of resin molded products that have been resin molded by the respective molding dies.

The present invention has been developed in view of the above-mentioned problems, and its main object is to provide a resin molding apparatus that clamps a plurality of molding dies that, while synchronizing the clamping of the plurality of molding dies, absorbs variations in the thickness, etc., of the object-to-be-molded in each molding die and performs resin molding.

### Means for Solving the Problem

A resin molding apparatus according to the present invention is characterized by comprising: a fixed platen; a movable platen that can be raised and lowered by a drive mechanism; an intermediate plate arranged between the fixed platen and the movable platen; molding dies, each including an upper die and a lower die, one of the molding dies being provided between the fixed platen and the intermediate plate and another of the molding dies being provided between the intermediate plate and the movable platen; a pair of side wall members arranged on both lateral sides of the movable platen and the intermediate plate; a slide mechanism that causes the intermediate plate to slide with respect to the pair of side wall members; and a raising-and-lowering linking mechanism that causes the raising and lowering of the intermediate plate to occur together with the raising and lowering of the movable platen; wherein the raising-and-lowering linking mechanism comprises a pantograph mechanism that extends and contracts due to the raising and lowering of the movable platen, and a coupling mechanism that couples a cross link part of the pantograph mechanism and the intermediate plate; and the coupling mechanism has a connecting member connected to the cross link part; a coupling member that couples the connecting member to the intermediate plate; and an elastic member interposed between the connecting member and the coupling member.

### Effect of the Invention

According to the present invention configured in this manner, in a resin molding apparatus that clamps a plurality of molding dies, it is possible to, while synchronizing the clamping of the plurality of molding dies, absorb variations in the thickness, etc., of the object-to-be-molded in each molding die and perform resin molding.

### Brief Description of the Drawings

FIG 1: A diagram schematically showing a configuration of a resin molding apparatus according to a first embodiment of the present invention.
FIG 2: A front view schematically showing a configuration of the resin molding apparatus of the first embodiment.
FIG 3: A side view schematically showing a configuration of the resin molding apparatus according to the first embodiment.
FIG 4: A diagram schematically showing a configuration of a molding die according to the first embodiment.
FIG 5: An enlarged cross-sectional view schematically showing a peripheral structure of a side wall member according to the first embodiment.
FIG 6: An enlarged view schematically showing a pantograph mechanism according to the first embodiment.
FIG 7: An enlarged cross-sectional view schematically showing a peripheral structure of an elastic member of the first embodiment.
FIG 8: A cross-sectional view schematically showing the operation of the elastic member of the first embodiment.
FIG 9: A front view schematically showing a configuration of a resin molding apparatus according to a second embodiment.
FIG 10: A side view schematically showing a configuration of the resin molding apparatus according to the second embodiment.
FIG 11: A side view, a cross-sectional view, and a front view schematically showing a peripheral structure of an elastic member according to a variation embodiment.

### Detailed Description of the Preferred Embodiments

Next, making reference to examples, the aspects of the present invention will be described in greater detail. However, the present invention is not limited by the aspects as described below.

A resin molding apparatus according to a first aspect of the present invention is characterized by comprising: a fixed platen; a movable platen that can be raised and lowered by a drive mechanism; an intermediate plate arranged between the fixed platen and the movable platen; molding dies, each including an upper die and a lower die, one of the molding dies being provided between the fixed platen and the intermediate plate and another of the molding dies being provided between the intermediate plate and the movable platen; a pair of side wall members arranged on both lateral sides of the movable platen and the intermediate plate; a slide mechanism that causes the intermediate plate to slide with respect to the pair of side wall members; and a raising-and-lowering linking mechanism that causes the raising and lowering of the intermediate plate to occur together with the raising and lowering of the movable platen; wherein the raising-and-lowering linking mechanism comprises a pantograph mechanism that extends and contracts due to the raising and lowering of the movable platen, and a coupling mechanism that couples a cross link part of the pantograph mechanism and the intermediate plate; and the coupling mechanism has a connecting member connected to the cross link part; a coupling member that couples the connecting member to the intermediate plate; and an elastic member interposed between the connecting member and the coupling member.

In a resin molding apparatus configured as such, the coupling mechanism that couples the cross link part of the pantograph mechanism and the intermediate plate has a connecting member connected to the cross link part, a coupling member that couples the connecting member to the intermediate plate, and an elastic member interposed between the connecting member and the coupling member, so that the clamping of a plurality of molding dies can be synchronized while absorbing variations in the thickness of the object-to-be-molded in each molding die.

For example, even if the thickness of the object-to-be-molded in the molding die on one side of the intermediate plate and the thickness of the object-to-be-molded in the molding die on the other side of the intermediate plate are different, the elastic members can be elastically deformed to absorb any variation in the thickness of the object-to-be-molded and the mold can be clamped. As a result, in a resin molding apparatus that clamps a plurality of molding dies, it is possible to, while synchronizing the clamping of the plurality of molding dies, absorb variations in the thickness of the object-to-be-molded in each molding die and perform resin molding.

Since the raising and lowering of the movable platen and the raising and lowering of the intermediate plate are made to occur together using the pantograph mechanism, it is possible to avoid a situation in which each component must be enlarged as well as avoid the need to increase the size of the entire apparatus, and highly rigid components are also made to be unnecessary.

The resin molding apparatus according to a second aspect of the present invention is one characterized in that, in addition to the configuration of the first aspect described above, a plurality of the intermediate plates are arranged along an up-and-down direction between the fixed platen and the movable platen; and one of the molding dies including the upper die and the lower die is provided between each of the plurality of intermediate plates.

With this configuration, the number of molding dies can be increased, thereby improving the productivity of manufacturing the resin molded products. Since the raising and lowering of the plurality of intermediate plates is made to occur together with the raising and lowering of the movable platen via the pantograph mechanism, even in a configuration in which molding dies are provided between each of a plurality of intermediate plates, it is possible to avoid a situation in which each component must be enlarged as well as avoid the need to increase the size of the entire apparatus, and highly rigid components are also made to be unnecessary.

A resin molding apparatus according to a third aspect of the present invention is one characterized in that, in addition to the configuration of the first or second aspect, the pantograph mechanism is provided on an exterior side of the side wall members; the coupling member extends to the exterior side of the side wall members; and the elastic member is provided on the exterior side of the side wall members.

Configured like this, since the pantograph mechanism is provided exterior to the side wall members and the elastic member is provided exterior to the side wall members, the number of members provided between the pair of side wall members can be reduced and the configuration simplified. The size of the intermediate plate arranged between the pair of side wall members can also be increased without being restricted by the pantograph mechanisms, elastic members, etc., thus increasing the size of molding dies attached to the intermediate plate and increasing the potential varieties of the molding dies.

A resin molding apparatus according to a fourth aspect of the present invention is one characterized in that, in addition to the configuration of any one of the first to the third aspects, the elastic member has a lower side elastic member that absorbs a downward displacement of the intermediate plate relative to the connecting member and an upper side elastic member that absorbs an upward displacement of the intermediate plate relative to the connecting member.

With this configuration, if the thickness of the object-to-be-molded in the molding die on one side of the intermediate plate (the upper surface side) is greater than the thickness of the object-to-be-molded in the molding die on the other side of the intermediate plate (the lower surface side), the lower side elastic member absorbs the variation in their thickness. On the other hand, if the thickness of the object-to-be-molded in the molding die on the other side of the intermediate plate (the lower surface side) is greater than the thickness of the object-to-be-molded in the molding die on one side of the intermediate plate (the upper surface side), the upper side elastic member absorbs the variation in their thickness.

A resin molding apparatus according to a fifth aspect of the present invention is one characterized in that, in addition to the configuration of any one of the first to the fourth aspects, the slide mechanism has a linear motion rail and a linear motion block that slides on said linear motion rail.

With this configuration, the extent to which the intermediate plate and movable platen are parallel to the fixed platen, as well as the extent to which the upper die and lower die of each molding die are parallel, can be maintained with high accuracy.

A resin molding apparatus according to a sixth aspect of the present invention is one characterized in that, in addition to the configuration of the fifth aspect, a side surface plate is connected to each of both lateral sides of the intermediate plate, the linear motion block is provided on one of the side surface plate or the side wall member, and the linear motion rail is provided on the other of the side surface plate or the side wall member.

Configured like this, the linear motion block or the linear motion rail is arranged on the side surface plate connected to the intermediate plate, so by making the up-and-down direction dimension of the side surface plate larger than the up-and-down direction dimension (thickness dimension) of the intermediate plate, the linear motion block or linear motion rail can be provided without regard to the thickness dimension of the intermediate plate.

A resin molding apparatus according to a seventh aspect of the present invention is one characterized in that, in addition to the configuration of the fifth or the sixth aspect, a side surface plate is connected to each of both lateral sides of the intermediate plate, the linear motion block is provided on the side surface plate, and the linear motion rail is provided on an inner surface of the side wall member.

Configured like this, the linear motion block is arranged on the side surface plate connected to the intermediate plate, so by making the up-and-down direction dimension of the side surface plate larger than the up-and-down direction dimension (thickness dimension) of the intermediate plate, the linear motion block can be provided without regard to the thickness dimension of the intermediate plate. Moreover, since the linear motion rail is arranged on the inner surface of the side wall member, the linear motion rail of the raising-and-lowering platen and the linear motion rail of the intermediate plate can be the same one, simplifying the configuration.

A resin molding apparatus according to an eighth aspect of the present invention is one characterized in that, in addition to the configuration of the seventh aspect, two of the linear motion rails are provided on the inner surface of the side wall member, and two rows of the linear motion blocks are provided on the side surface plate corresponding to the two linear motion rails.

With this configuration, the extent to which the intermediate plate and movable platen are parallel to the fixed platen, as well as the extent to which the upper die and lower die of each molding die are parallel, can be maintained with even higher accuracy.

A resin molding apparatus according to a ninth aspect of the present invention is one characterized in that, in addition to the configuration of any one of the sixth to the eighth aspect, in a configuration having a plurality of the intermediate plates, the side surface plates respectively connected to the plurality of intermediate plates are displaced in a horizontal direction so as not to interfere with each other.

With this configuration, the side surface plates of each intermediate plate do not interfere with each other when the plurality of intermediate plates are raised and lowered, thus reducing the height dimension of the resin molding apparatus. That is, if the side surface plates of each intermediate plate were not displaced in the horizontal direction, the side surface plates would have to be placed with enough room in the up-and-down direction to prevent interference, which would increases the height dimension of the resin molding apparatus.

A resin molding apparatus according to a tenth aspect of the present invention is one characterized in that, in addition to the configuration of any one of the first to the ninth aspect, it further comprises a guide mechanism interposed between the connecting member and either the coupling member or the side wall member, and in that the guide mechanism has a linear motion rail provided on one of (i) the connecting member or (ii) either of the coupling member or the side wall member and a linear motion block provided on the other of (i) the connecting member or (ii) either of the coupling member or the side wall member.

With this configuration, the connecting member connected to the cross link part of the pantograph mechanism can be raised and lowered in a stable manner.

A resin molded product manufacturing method for manufacturing a resin molded product that is an aspect of the present invention is one using the resin molding apparatus according to any one of the first to tenth aspects, and includes a resin molding process in which, in a state in which an object-to-be-molded and a resin material have been supplied to the molding dies, the molding dies are clamped and resin molding is performed using the raising-and-lowering linking mechanism and a removal process in which the molding dies are opened using the raising-and-lowering linking mechanism and the object-to-be-molded that has been resin-molded is removed from the mold.

### First Embodiment of the Present Invention

A first embodiment of a resin molding apparatus according to the present invention will be described below with reference to the drawings. Moreover, for ease of understanding, each of the drawings shown below are drawn schematically with some parts omitted or exaggerated where appropriate. The same components are denoted by the same reference numerals and the description thereof will be omitted as appropriate.

### Overall Configuration of Resin Molding Apparatus

The resin molding apparatus 100 according the first embodiment is one that manufactures resin molded products P by resin sealing an electronic component Wx fixed on a substrate W, which is the object-to-be-molded, via resin molding using a resin material J. Examples of the substrate include a metal substrate, a resin substrate, a glass substrate, a ceramic substrate, a circuit board, a semiconductor substrate, a lead frame, a silicon wafer, and a glass wafer. Examples of the resin material J include powdered resin (including a granular resin), liquid resin, and so on. Examples of the electronic component Wx include electronic elements such as semiconductor chips, resistor elements, or capacitor elements, or also an electronic component formed by sealing at least one of said electronic elements with resin.

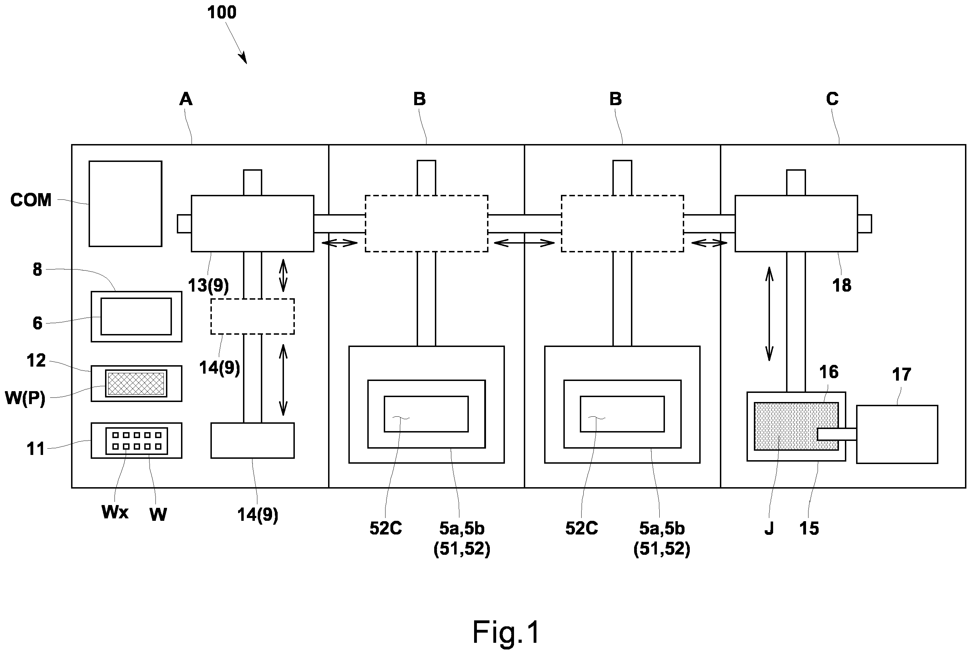

As shown in FIG 1, the resin molding apparatus 100 includes a substrate supplying and storing module A, two resin molding modules B, and a resin material supply module C as its respective components. Each of the components (each module A to C) is detachable and replaceable with respect to the other components.

The substrate supplying and storing module A has a substrate receiving unit 11 that receives substrates W that have not yet been molded from an exterior, a substrate storage unit 12 that stores substrates W that have been molded (resin molded products P), a conveying mechanism 13 that conveys substrates W that have not yet been molded and resin molded products P, and a transfer mechanism 14, such as a conveyance robot, that transfers substrates W that have not yet been molded and resin molded products P to the conveying mechanism 13.

The conveying mechanism 13 conveys a substrate W that has not yet been molded from the substrate supplying and storing module A to the resin molding module B and, in the resin molding module B, supplies the substrate W that has not yet been molded to the molding dies 5a, 5b. After said substrate W is resin molded, the conveying mechanism 13 receives the resin molded product P, which is the substrate W after having been resin molded, from the molding dies 5a, 5b in the resin molding module B and conveys it to the substrate supplying and storing module A. In addition, the transfer mechanism 14 transfers the substrate W that has not yet been molded from the substrate receiving unit 11 to the conveying mechanism 13, and transfers the resin molded product P from the conveying mechanism 13 to the substrate storage unit 12.

Each resin molding module B has an upper die 51 which is a first die that holds the substrate W, and a lower die 52 which is a second die in which a cavity 52C is formed, and by clamping these together, the electronic component Wx fixed to the substrate W is resin-sealed by resin molding using a resin material J. The specific configuration of the resin molding module B will be described later.

The resin material supply module C has a moving table 15, a resin material accommodation unit 16 placed on the moving table 15, a resin material providing mechanism 17 that measures and provides resin material J to the resin material accommodation unit 16, and a resin material supply mechanism 18 that transports the resin material accommodation unit 16 and supplies resin material J to the cavity 52C of the lower die 52.

In the resin material supply module C, the moving table 15 moves between a resin providing position where the resin material providing mechanism 17 provides resin material and a transfer position for transferring the resin material accommodation unit 16 to the resin material supply mechanism 18. The resin material supply mechanism 18 transports the resin material accommodation unit 16, which contains resin material J, from the resin material supply module C to the resin molding module B, and supplies resin material J to the molding dies 5a and 5b in the resin molding module B. The resin material supply mechanism 18 then conveys the resin material accommodation unit 16, after it has supplied the resin material J, from the resin molding module B to the resin material supply module C.

### Specific Configuration of the Resin Molding Module B

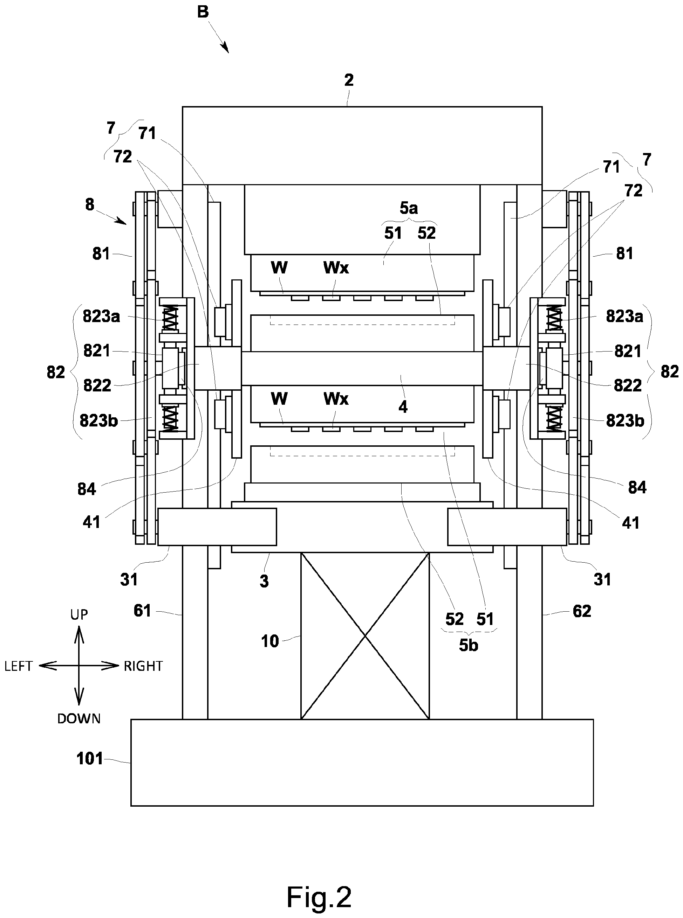

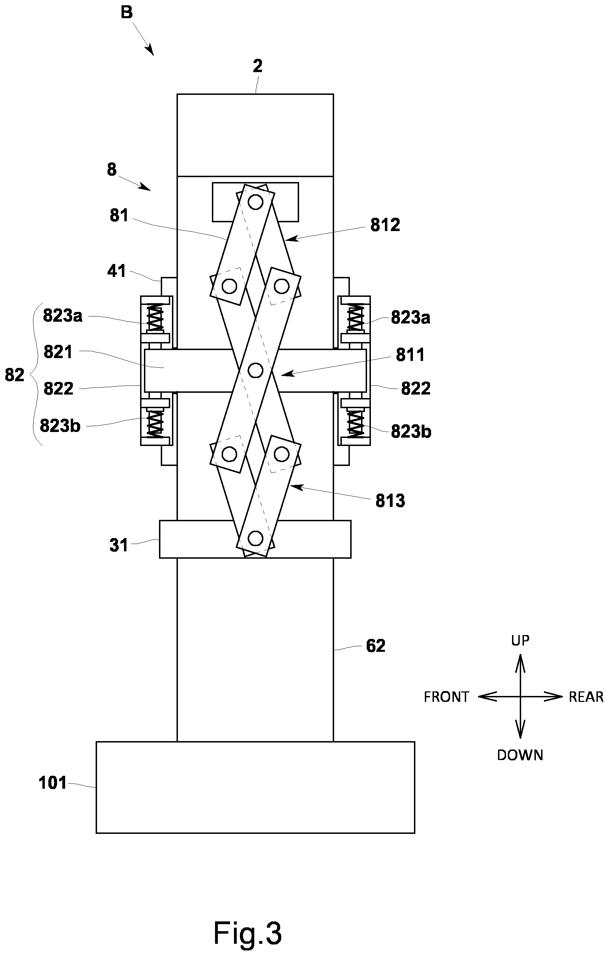

As shown in FIGs 2 and 3, the resin molding module B includes a fixed platen 2; a movable platen 3 that can be raised and lowered by a drive mechanism 10; an intermediate plate 4 arranged between the fixed platen 2 and the movable platen 3; a first molding die 5a and a second molding die 5b each including an upper die 51 and a lower die 52, respectively provided between the fixed platen 2 and the intermediate plate 4 and between the intermediate plate 4 and the movable platen 3; a pair of side wall members 61, 62 arranged on both lateral sides (here, on the left and right side) of the movable platen 3 and intermediate plate 4; a slide mechanism 7 that causes the intermediate plate 4 to slide with respect to the pair of side wall members 61 and 62; and a raising-and-lowering linking mechanism 8 that causes the raising and lowering of the intermediate plate 4 to occur together with the raising and lowering of the movable platen 3.

The upper die 51 of the first molding die 5a is removably attached to the lower surface of the fixed platen 2 directly or via another component. Also, the pair of side wall members 61 and 62 are connected to the left and right sides of the fixed platen 2. It is also possible for the pair of side wall members 61 and 62 to be formed integrally with the fixed platen 2. The fixed platen 2 of the present embodiment takes the form of a flat plate that is roughly rectangular in plan view.

The lower die 52 of the second molding die 5b is removably attached to the upper surface of the movable platen 3 directly or via another component. The movable platen 3 is raised and lowered by the drive mechanism 10 provided below the movable platen 3. The movable platen 3 of the present embodiment takes the form of a flat plate that is roughly rectangular in plan view. A fixing member 31 is connected to the movable platen 3, and a lower end section (lower end link part 813) of the pantograph mechanism 81, described below, is fixed to the fixing member 31.

The drive mechanism 10 of the present embodiment is a linear motion system that raises and lowers the movable platen using a ball screw mechanism that converts rotation of a servomotor or the like into linear movement, but it may also be a link system that transmits power from a power source such as a servomotor to the movable platen using a link mechanism such as a toggle link, for example.

The lower die 52 of the first molding die 5a is removably attached to the upper surface of the intermediate plate 4 directly or via another component. The upper die 51 of the second molding die 5b is removably attached to the lower surface of the intermediate plate 4 directly or via another component. The intermediate plate 4 of the present embodiment takes the form of a flat plate that is roughly rectangular in plan view.

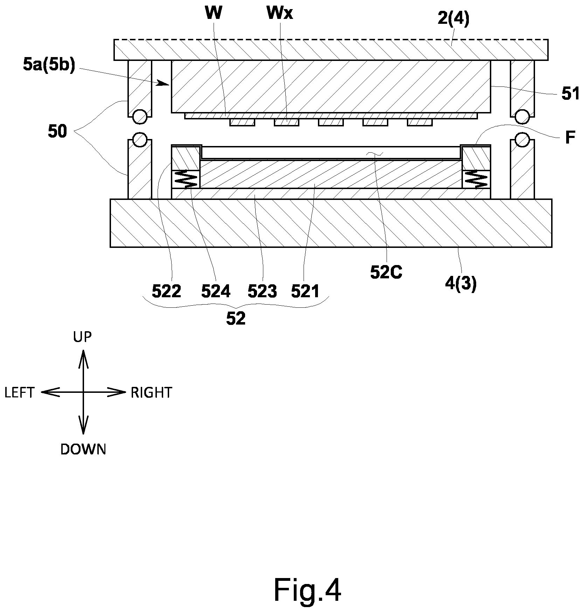

Next, the first molding die 5a and second molding die 5b will be described with reference to FIG 4.

The upper die 51 of each molding die 5a, 5b holds the back surface of the substrate W by suction. A suction opening (not shown) is formed on the lower surface of the upper die 51, and a suction channel (not shown) leading to the suction opening is formed within the upper die 51. The suction channel is connected to an external suction apparatus (not shown)

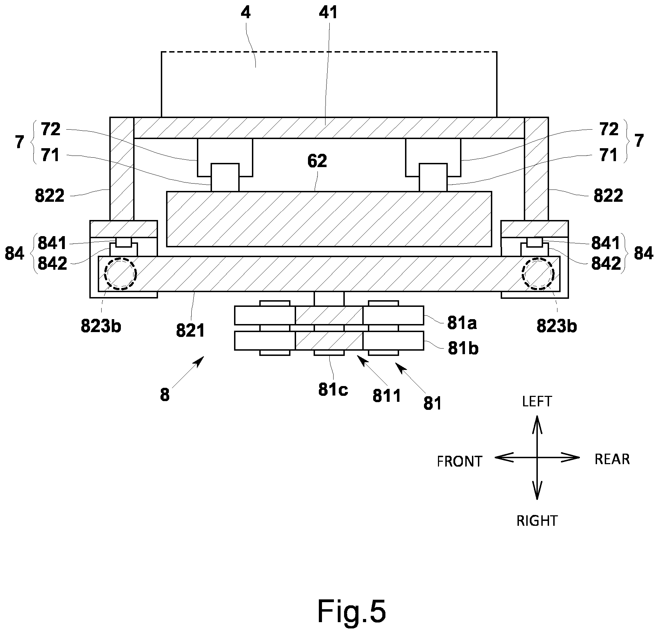

The lower die 52 of each molding die 5a, 5b has a cavity 52C that accommodates an electronic component Wx fixed to a substrate W and resin material J. Specifically, the lower die 52 has a bottom surface member 521 that forms the bottom surface of the cavity 52C and a side surface member 522 that surrounds the bottom surface member 521. The cavity 52C is formed by an upper surface of the bottom surface member 521 and an inner circumferential surface of the side surface member 522. The side surface member 522 is provided so as to be movable up and down relative to the bottom surface member 521. Specifically, the side surface member 522 is supported by a plurality of elastic members 524, which may be coil springs or the like, with respect to a base plate 523 of the lower die 52. Furthermore, the lower die 52 of the present embodiment is covered with a die release film F to improve the ability of the resin molded product P to be released from the die. An air vent (not shown) may also be provided on the upper surface of the side surface member 522 (the contact surface between the side surface member 522 and the substrate W) to exhaust air or gas. Besides this, a sealing structure 50 (not shown in FIGs 2 and 5) is be provided around the upper die 51 and lower die 52 and consists of side wall portions and sealing members such as O-rings or the like to draw a vacuum around the molding dies 5a and 5b during resin molding.

As shown in FIGs 2 and 3, the pair of side wall members 61, 62 fix the fixed platen 2 at a predetermined height relative to a base member 101, and also support the intermediate plate 4 so that it is slidable. Here, the upper end section of each of the side wall members 61, 62 is connected to the fixed platen 2, and the lower end sections of the side wall members 61, 62 are connected to the base member 101. Moreover, in the present embodiment, each of the side wall members 61, 62 takes the form of a vertically elongated flat plate extending in the up-and-down direction.

The slide mechanisms 7 causes linear movement of the intermediate plate 4 along the up-and-down direction with respect to the pair of side wall members 61, 62. Specifically, the slide mechanism 7 has one or more linear motion rails 71 that extend in a straight line and one or more linear motion blocks 72 that slide on said linear motion rail 71.

In the present embodiment, side surface plates 41, which have a flat plate shape, are connected to both the left and right side of the intermediate plate 4, the linear motion blocks 72 are provided on said side surface plates 41, and the linear motion rails 71 are provided along the inner surfaces of side wall members 61 and 62 along the up-and-down direction (the vertical direction).

In detail, as shown in FIG 5, two linear motion rails 71 are provided on the inner surface of each side wall member 61, 62 in parallel towards the front and rear, and linear motion blocks 72 corresponding to the two linear motion rails 71 are provided in two rows on each side surface plate 41. Here, a row of linear motion blocks 72 on each side surface plate 41 is configured to have two linear motion blocks 72 (see FIG 2). In other words, a total of four linear motion blocks 72 are provided to each side surface plate 41.

In detail, as shown in FIGs 2 and 5, two linear motion rails 71 are provided on the inner surface of each side wall member 61, 62. Here, the two linear motion rails 71 extend in an up-and-down direction (vertical direction). Furthermore, the two linear motion rails 71 are arranged so as to be lined up in a front-to-rear direction. On the other hand, the linear motion blocks 72 are provided on each side surface plate 41. Here, the linear motion blocks 72 are arranged so as to line up in two rows in the front-to-rear direction on each side surface plate 41, so as to correspond to the two linear motion rails 71. The linear motion blocks 72 are arranged on each side surface plate 41, with two in each row in the up-and-down direction (vertical direction). In other words, a total of four linear motion blocks 72 are provided to each side surface plate 41.

As shown in FIGs 2, 3, and 5 - 7, the raising-and-lowering linking mechanism 8 synchronizes the mold clamping and mold opening of the first molding die 5a and the second molding die 5b by causing the raising and lowering of the intermediate plate 4 to occur together with the raising and lowering of the movable platen 3. In other words, the raising-and-lowering linking mechanism 8 allows for simultaneous clamping of the molding dies while causing the mold clamping speed of the first molding die 5a and the mold clamping speed of the second molding die 5b to be the same.

Specifically, the raising-and-lowering linking mechanism 8 has a pantograph mechanism 81 that extends and contracts as the movable platen 3 is raised and lowered, and a coupling mechanism 82 that couples a cross link part 811 of the pantograph mechanism 81 and the intermediate plate 4.

As shown in FIG 2, a pantograph mechanism 81 is arranged on each of the left and right exterior sides of the pair of side wall members 61, 62. In other words, the raising and lowering of the movable platen 3 and the intermediate plate 4 is made to occur together due to the two pantograph mechanisms 81 on the left and right. Moreover, the configurations of the left and right pantograph mechanisms 81 are identical to each other.

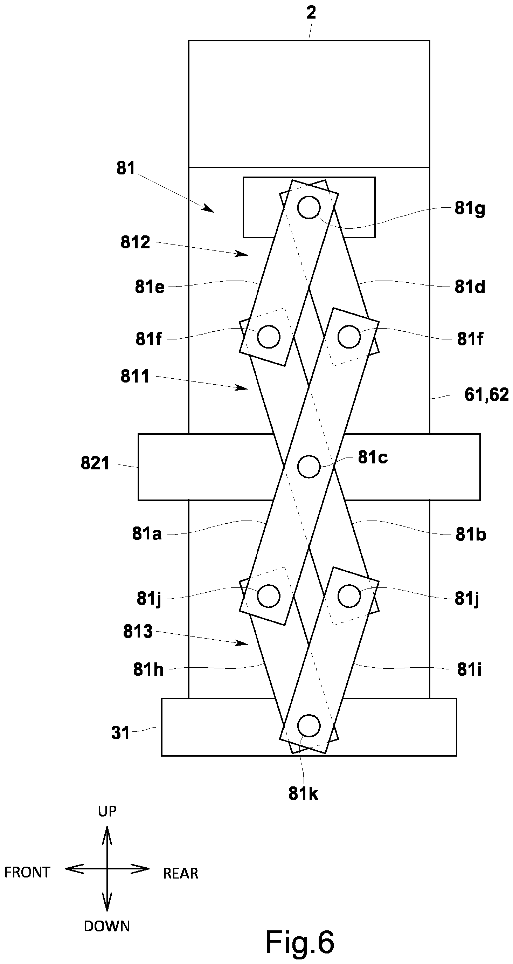

Specifically, as shown in FIGs 3 and 6, each pantograph mechanism 81 has a configuration including one cross link part 811, as well as an upper end link part 812 and a lower end link part 813. The cross link part 811 consists of a first link 81a and a second link 81b that intersect each other at their center portion, and their intersecting portions are rotatably connected by a rotary shaft 81c. The upper end link part 812 is such that the lower end section of each of a third link 81d and a fourth link 81e are rotatably connected to the upper end section of each of the first link 81a and second link 81b by a rotary shaft 81f, respectively, and the upper end section of each of the third link 81d and the fourth link 81e are rotatably connected to each other by a rotary shaft 81g. The lower end link part 813 is such that the upper end section of each of a fifth link 81h and a sixth link 81i are rotatably connected to the lower end section of each of the first link 81a and second link 81b by a rotary shaft 81j, respectively, and the lower end section of each of the fifth link 81h and the sixth link 81i are rotatably connected to each other by a rotary shaft 81k.

The upper end section of the pantograph mechanism 81 (the upper end link part 812) is fixed to the upper end section of the side wall members 61, 62, and the lower end section of the pantograph mechanism 81 (the lower end link part 813) is fixed to the fixing member 31 that moves with the movable platen 3. Therefore, the lower end section of the pantograph mechanism 81 (the lower end link part 813) is connected to the movable platen 3 via the fixing member 31 and moves in accordance with the movement of the movable platen 3. In the present embodiment, as shown in FIG 6, the rotary shaft 81c of the cross link part 811, the rotary shaft 81g of the upper end link part 812, and the rotary shaft 81k of the lower end link part 813 of the pantograph mechanism 81 are arranged along the up-and-down direction (the vertical direction), and are located in the center portion in the width direction of the side wall members 61, 62 in the side view.

As shown in FIGs 2, 3, 5, and 7, the coupling mechanism 82 couples the cross link part 811 of the pantograph mechanism 81 and the intermediate plate 4. Specifically, the coupling mechanism 82 has a connecting member 821 connected to the cross link part 811, a coupling member 822 that couples the connecting member 821 to the intermediate plate 4, and elastic members 823a, 823b that are interposed between the connecting member 821 and the coupling member 822. Moreover, the configurations of the left and right linking mechanism 82 are identical to each other.

As shown in FIGs 3, 5, and 6, the connecting member 821 is connected to the cross link part 811 without interfering with the extension and contraction of the pantograph mechanism 81. Specifically, the connecting member 821 has a long rectangular shape, and its center portion is connected to the rotary shaft 81c of the cross link part 811. The connecting member 821 is provided so as to extend in the front-to-rear direction (the horizontal direction).

The coupling member 822 couples the connecting member 821 to the intermediate plate 4, and in the present embodiment is respectively connected to the side surface plates 41 connected to each of both lateral sides (here, the left and the right sides) of the intermediate plate 4 (see FIG 2). The coupling member 822 extends to an exterior side from the front and rear of the side wall members 61, 62 (see FIG 5).

The elastic members 823a, 823b are provided to absorb variations in the thickness and the like of the substrate W, and are interposed between the coupling member 822 and the connecting member 821. The elastic members 823a, 823b are provided on the outside of the side wall members 61, 62.

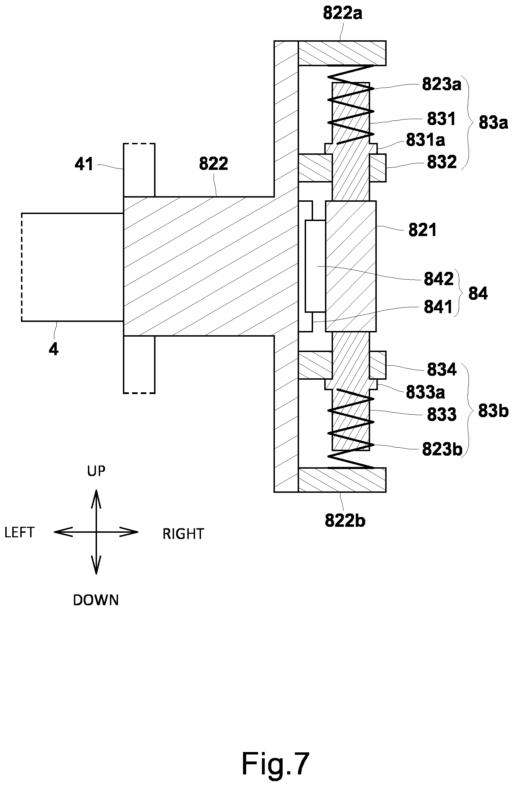

Specifically, as shown in FIGs 2, 3, 5 and 7, the elastic members 823a, 823b include an upper side elastic member 823a that absorbs upward displacement of the intermediate plate 4 relative to the connecting member 821 and a lower side elastic member 823b that absorbs downward displacement relative to the connecting member 821. As shown in FIG 7, these elastic members 823a, 823b are components of displacement absorbing mechanisms 83a, 83b provided to the coupling member 822.

The displacement absorbing mechanisms 83a, 83b are respectively provided on the upper side and the lower side of the connecting member 821 in the coupling member 822. The displacement absorbing mechanism 83a on the upper side has an upper side contact part 831 that contacts the upper surface of the connecting member 821, an upper side elastic member 823a that applies force to (biases) said upper side contact part 831 toward the upper surface of the connecting member 821, and an upper side support part 832 that supports the upper side contact part 831 so as to be movable in an upward direction. The displacement absorbing mechanisms 83b on the lower side has a lower side contact part 833 that contacts the lower surface of the connecting member 821, a lower side elastic member 823b that applies force to (biases) said lower side contact part 833 toward the lower surface of the connecting member 821, and a lower side support part 834 that supports the lower side contact part 833 so as to be movable in a downward direction. The upper side support part 832 and the lower side support part 834 are fixed to the coupling member 822.

Here, the upper side contact part 831 is formed with an upper side stopper 831a that protrudes around its circumference so as to be able to contact the upper surface of the upper side support part 832 and limit downward movement. The lower side contact part 833 is formed with a lower side stopper 833a that protrudes around its circumference so as to be able to contact the lower surface of the lower side support part 834 and limit upward movement.

The coupling member 822 has an upper side protruding portion 822a that protrudes to form an opposing surface on the upper side of the upper end surface of the upper side contact part 831 and a lower side protruding portion 822b that protrudes to form an opposing surface on the lower side of a lower end surface of the lower side contact part 831. A gap is provided between the upper end surface of the upper side contact part 831 and the lower surface of the upper side protruding portion 822a of the coupling member 822 (the opposing surface to the upper end surface of the upper side contact part 831) that is large enough that they do not make contact with one another due to the operation of the displacement absorbing mechanisms 83a, 83b as described below. A gap is also provided between the lower end surface of the lower side contact part 833 and the upper surface of the lower side protruding portion 822b of the coupling member 822 (the opposing surface to the lower end surface of the lower side contact part 833) that is large enough that they do not make contact with one another due to the operation of the displacement absorbing mechanisms 83a, 83b as described below.

The basic operation of the displacement absorbing mechanisms 83a, 83b will now be described.

In the initial state of the displacement absorbing mechanisms 83a, 83b (see FIG 7), the elastic member 823a is such that its upper end contacts the lower surface of the upper side protruding portion 822a of the coupling member 822 (the opposing surface to the upper end surface of the upper side contact part 831), its lower end contacts the upper surface of the upper side stopper 831a of the upper side contact part 831, and it is in a state of not being expanded or contracted. Moreover, in the initial state of the displacement absorbing mechanisms 83a, 83b, the elastic member 823b is such that its upper end contacts the lower surface of the lower side stopper 833a of the lower side contact part 833, its lower end contacts the upper surface of the lower side protruding portion 822b of the coupling member 822 (the opposing surface to the lower end surface of the lower side contact part 833), and it is in a state of not being expanded or contracted.

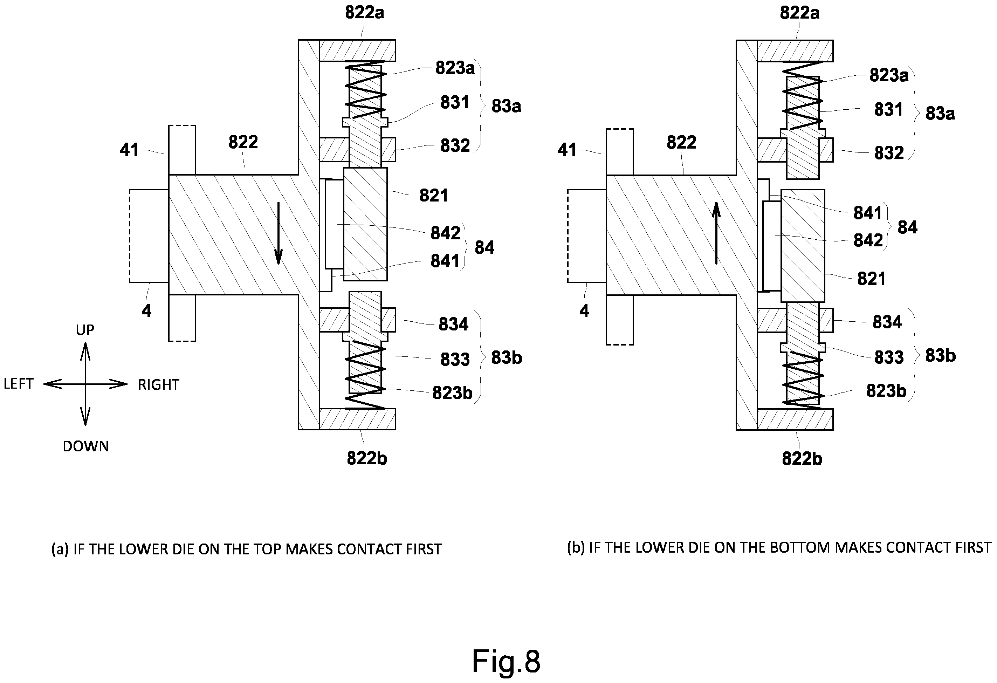

Then, as shown in FIG 8(a), when the intermediate plate 4 is displaced downward relative to the connecting member 821, the coupling member 822 connected to the intermediate plate 4 is displaced downward relative to the connecting member 821. When this happens, with the connecting member 821 and the upper side contact part 831 in a state of rest, the upper side support part 832 and the upper side protruding portion 822a of the coupling member 822 are also displaced relatively downward, so that the upper side elastic member 823a contracts. In other words, the connecting member 821 and the upper side contact part 831 move upward relative to the upper side protruding portion 822a of the coupling member 822, and the upper side elastic member 823a contracts. Thanks to this, the downward displacement of the intermediate plate 4 relative to the connecting member 821 is absorbed.

On the other hand, as shown in FIG 8(b), when the intermediate plate 4 is displaced upward relative to the connecting member 821, the coupling member 822 connected to the intermediate plate 4 is displaced upward relative to the connecting member 821. When this happens, with the connecting member 821 and the lower side contact part 833 in a state of rest, the lower side support part 834 and the lower side protruding portion 822b of the coupling member 822 are also displaced relatively upward, so that the lower side elastic member 823b contracts. In other words, the connecting member 821 and the lower side contact part 833 move downward relative to the lower side protruding portion 822b of the coupling member 822, and the lower side elastic member 823b contracts. Thanks to this, the upward displacement of the intermediate plate 4 relative to the connecting member 821 is absorbed.

Furthermore, as shown in FIGS 2, 5, and 7, the resin molding apparatus 100 of the present embodiment is further provided with a guide mechanism 84 interposed between the connecting member 821 and the coupling member 822. The guide mechanism 84 guides the movement of the connecting member 821 and the coupling member 822 when they move relative to each other.

The guide mechanism 84 guides the movement in the up-and-down direction of the connecting member 821 and is provided between the opposing surfaces of the connecting member 821 and the coupling member 822. Specifically, the guide mechanism 84 has a linear motion rail 841 provided on one of either the connecting member 821 or the coupling member 822 and a linear motion block 842 provided on the other of the connecting member 821 or the coupling member 822. In the present embodiment, the linear motion rail 841 is provided on the coupling member 822 and the linear motion block 842 is provided on the connecting member 821.

### Example Operation of Resin Molding Apparatus

Next, an example of the operation of the resin molding apparatus 100 is described with reference to FIGs 1, 2, 4, and 8. The operation as described below is performed, for example, by a control unit COM provided in the substrate supplying and storing module A that controls each part of the resin molding apparatus 100. The control unit COM is a dedicated or general-purpose computer with a CPU, internal memory, input/output interface, AD converter, etc.

First, with each of the molding dies 5a, 5b in a state of having been opened by the raising-and-lowering linking mechanism 8 (see FIG 2), the substrate W is conveyed and held in the upper die 51 of each molding die 5a, 5b by the substrate supplying and storing module A shown in FIG 1. The resin material J is contained in the cavity 52C of the lower die 52 of each molding die 5a, 5b by the resin material supply module C. In this way, the substrate W, which is the object-to-be-molded, and resin material J are supplied to each molding die 5a, 5b

Next, the movable platen 3 is raised by the drive mechanism 10. The pantograph mechanism 81 contracts as the movable platen 3 is raised, and the intermediate plate 4 connected to the rotary shaft 81c of the cross link part 811 of the pantograph mechanism 81 rises. Here, as the movable platen 3 is raised, the sealing structure 50 shown in FIG 5 seals the circumference around the molding dies 5a, 5b, and a vacuum pump, not shown, draws a vacuum around the molding dies 5a, 5b.

The upper surface of the lower die 52 of each molding die 5a, 5b (specifically, the upper surface of the side surface member 522 or the die release film F in cases in which there is die release film F) contacts the substrate W held by suction to the upper die 51. At such a time, if the lower dies 52 in the first molding die 5a and the second molding die 5b make contact with the upper dies 51 at different times, the upper side elastic member 823a or the lower side elastic member 823b will deform before the elastic member 524 of the lower die 52. In other words, the spring constants of the upper side elastic member 823a and the lower side elastic member 823b are smaller than the spring constant of the elastic member 524 of the lower die 52.

For example, when the lower die 52 atop the intermediate plate 4 (lower die 52 of the first molding die 5a) makes contact with the substrate W held by suction to the corresponding upper die 51 before the lower die 52 atop the movable platen 3 (the lower die 52 of the second molding die 5b), the intermediate plate 4 is displaced downward with respect to the connecting member 821 and the upper side elastic member 823a contracts (see FIG 8(a)).

On the other hand, when the lower die 52 atop the movable platen 3 (the lower die 52 of the second molding die 5b) makes contact with the substrate W held by suction to the corresponding upper die 51 before the lower die 52 atop the intermediate plate 4 (the lower die 52 of the first molding die 5a), the intermediate plate 4 is displaced upward with respect to the connecting member 821 and the lower side elastic member 823b contracts (see FIG 7(b)).

These allow the mold clamping operation to be performed while eliminating differences in the timing of the lower die 52 contacting the upper die 51 in the first molding die 5a and the second molding die 5b. The upper side elastic member 823a and lower side elastic member 823b absorb not only variations in the thickness of the substrate W, but also variations in the amount of resin material J contained in the cavity 52C, variations in the volume of the electronic components Wx fixed to the substrate W, and so on.

The drive mechanism 10 then further raises the movable platen 3 to complete the mold clamping of the first molding die 5a and the second molding die 5b, and resin molding is completed by maintaining this state for a predetermined time (for example, the curing time of resin material J). In this way, each molding die 5a, 5b is clamped using the raising-and-lowering linking mechanism 8, and resin molding is performed. The drive mechanism 10 then lowers the movable platen 3, causing each molding die 5a, 5b to open. The resin molded product P is then stored in the substrate storage part 12 by the substrate supplying and storing module A (see FIG 1). In this way, each molding die 5a, 5b is opened using the raising-and-lowering linking mechanism 8, and the substrate W that is the object-to-be-molded that has been resin molded (resin molded product P) is removed from each molding die 5a, 5b and stored in the substrate storage part 12, and the resin molded product P is thus manufactured.

### Effect of the First Embodiment

According to the resin molding apparatus 100 of the present embodiment, the coupling mechanism 82, that couples the cross link part 811 of the pantograph mechanism 81 and the intermediate plate 4, has a connecting member 821 connected to the cross link part 811, a coupling member 822 that couples the connecting member 821 to the intermediate plate 4, and elastic members 823a, 823b interposed between the connecting member 821 and the coupling member 822, so that variations in the thickness and the like of the substrate W in each molding die 5a and 5b can be absorbed.

For example, even if the thickness of the substrate W held in the upper die 51 of the first molding die 5a and the thickness of the substrate W held in the upper die 51 of the second molding die 5b vary, the molds can be clamped while absorbing such variations in the thickness or the like of the substrate W thanks to the elastic deformation of the elastic members 823a, 823b. As a result, in the resin molding apparatus 100 that clamps a plurality of molding dies 5a, 5b it is possible to, while synchronizing the clamping of the plurality of molding dies 5a, 5b, absorb variations in the thickness, etc., of the object-to-be-molded in each molding die and perform resin molding.

Since the raising and lowering of the movable platen 3 and the raising and lowering of the intermediate plate 4 is made to occur together using the pantograph mechanism 81, it is possible to avoid a situation in which each component must be enlarged as well as avoid the need to increase the size of the entire apparatus, and highly rigid components are also made to be unnecessary.

### Second Embodiment of the Present Invention

A second embodiment of the present invention will now be explained. In the following, parts that differ from the first embodiment will be explained, and parts that are the same will be indicated by the same reference numeral.

The resin molding apparatus 100 according the second embodiment differs from that of the first embodiment (which is a configuration with two sets of molding dies using one intermediate plate 4) in that it is configured to have a plurality of sets of molding dies using a plurality of intermediate plates 4. For example, it may be configured to have three sets of molding dies using two intermediate plates 4, to have four sets of molding dies using three intermediate plates 4, to have five sets of molding dies using four intermediate plates 4, or to have six or more molding dies using five or more intermediate plates 4.

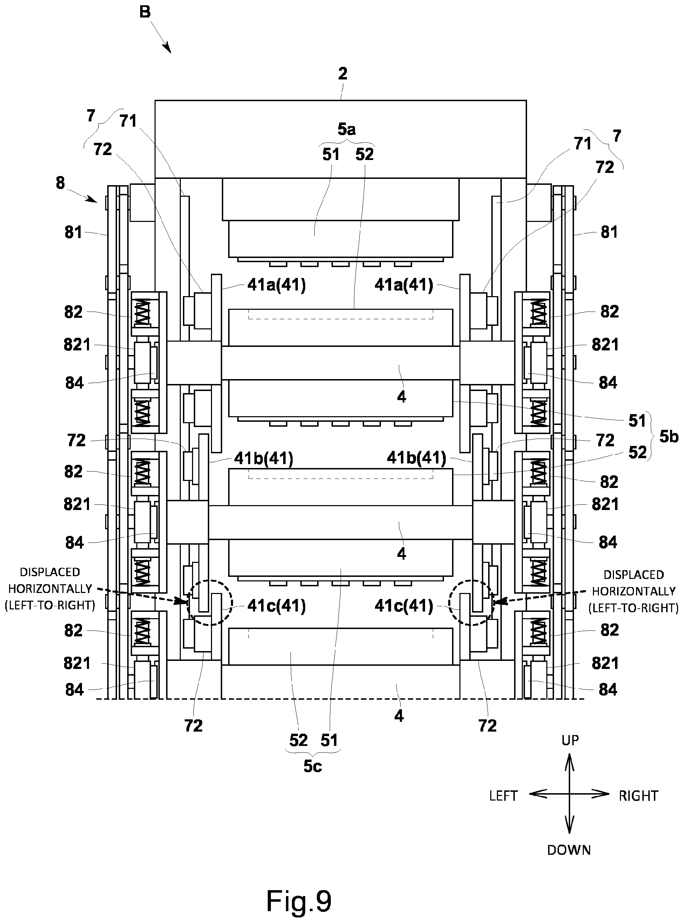

Specifically, as shown in FIG 9, in the resin molding apparatus 100, a plurality of intermediate plates 4 are arranged along the up-and-down direction between the fixed platen 2 and the movable platen 3. Molding dies 5b, 5c, which include an upper die 51 and a lower die 52, are respectively provided between the plurality of intermediate plates 4. In FIG 8, the configuration from the fixed platen 2 up until three intermediate plates 4 is shown, and the lower part is omitted.

Each of the plurality of intermediate plates 4 is connected to each of the plurality of cross link parts 811 of the pantograph mechanism 81 via a coupling mechanism 82, as in the first embodiment described above. As a result, the raising and lowering of the plurality of intermediate plates 4 is made to occur together with the raising and lowering of the movable platen 3.

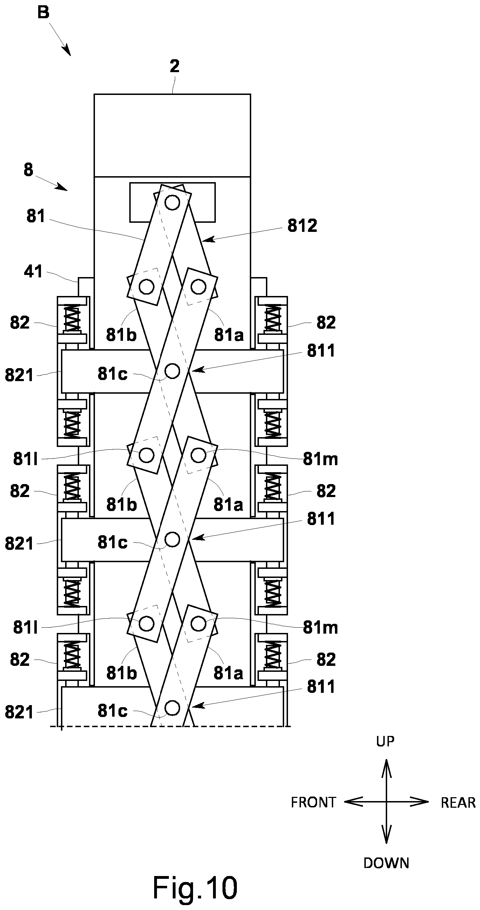

Here, as shown in FIG 10, the pantograph mechanism 81 is configured to have a plurality of cross link parts 811 of a number corresponding to the number of the plurality of intermediate plates 4, as well as an upper end link part 812 and a lower end link part 813. The plurality of cross link parts 811 are connected in series. Specifically, in adjacent cross link parts 811, the upper end section of the first link 81a of one cross link part 811 is rotatably connected to the upper end section of the second link 81b of the other cross link part 811 by a rotary shaft 811, and the upper end section of the second link 81b of one cross link part 811 is rotatably connected to the upper end section of the first link 81a of the other cross link part 811 by a rotary shaft 81m. The configuration of the upper end link part 812 and the lower end link part 813 is the same as in the first embodiment.

The side surface plates 41 connected to each of the plurality of intermediate plates 4 are displaced in the horizontal direction so as not to interfere with each other. Specifically, as shown in FIG 9, the side surface plates 41 of adjacent intermediate plate 4 in the up-and-down direction are arranged so that they are displaced to the left and right (in the horizontal direction) and so as to alternate.

For example, the side surface plate 41a of the first intermediate plate 4 from the top is positioned on the inner side and the side surface plate 41b of the second intermediate plate 4 from the top is positioned on the exterior side. Meanwhile, the side surface plate 41b of the second intermediate plate 4 from the top is positioned on the exterior side and the side surface plate 41c of the third intermediate plate 4 from the top is positioned on the inner side. Here, so that the side surface plate 41b of the second intermediate plate 4 from the top does not impede the movement of the linear motion blocks 842 located on the side surface plates 41a, 41c (first from the top and third from the top) located on the inner side, a through hole or notch or the like not shown in the figures is formed over the range of movement of said linear motion blocks 842.

### Effect of the Second Embodiment

According to the resin molding apparatus 100 of the present embodiment, in addition to the effects of the first embodiment described above, resin molding can be performed using three or more molding dies 5a - 5c, thereby improving the productivity of manufacturing the resin molded products P. The side surface plates 41 of the plurality of intermediate plates 4 are arranged so as to be displaced in the horizontal direction so that they do not interfere with each other, thereby allowing the height dimension of the resin molding apparatus 100 to be reduced.

### Other Variation Embodiments

The present invention is not limited to the aforementioned embodiments.

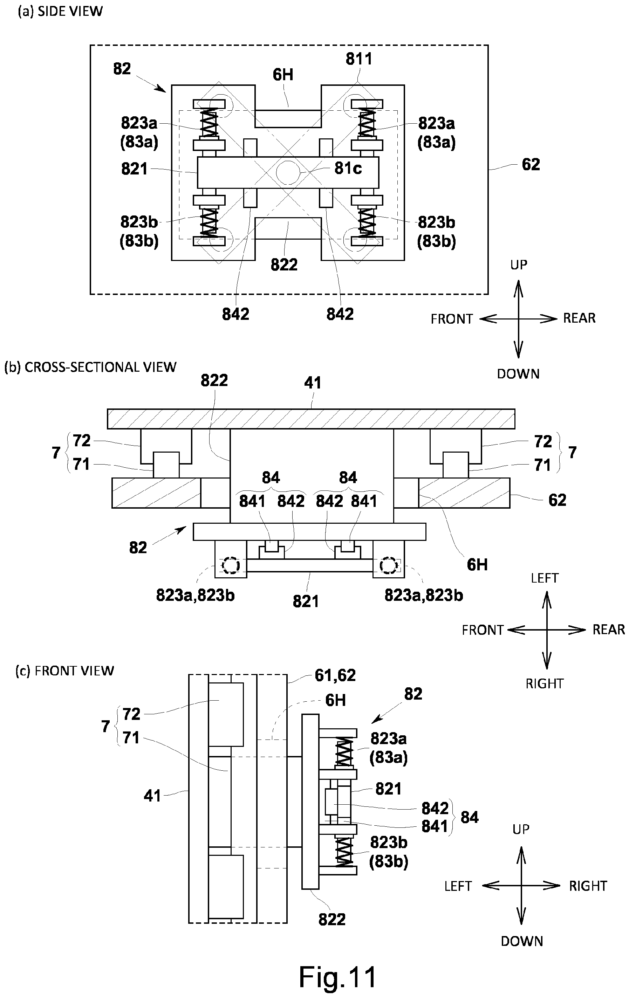

For example, the above embodiments were configured such that the coupling member 822 extends outward from the front and rear of the side wall members 61, 62, but as shown in FIG 11, the coupling member 822 and the connecting member 821 may be configured to be connected through a through portion 6H formed in the side wall members 61, 62.

Specifically, a through portion 6H is formed in the side wall members 61, 62 corresponding to the cross link part 811. Here, the through portion 6H is formed so that it does not interfere with the movement of the coupling member 822, taking into account the extent to which the intermediate plate 4 moves. The coupling member 822 is connected to the side surface plate 41 of the intermediate plate 4 and extends outward from the side wall members 61, 62 through the through portion 6H of the side wall members 61, 62 to support the elastic members 823a, 823b (the displacement absorbing mechanisms 83a, 83b) on the exterior side of the side wall members 61, 62. The elastic members 823a, 823b (displacement absorbing mechanisms 83a, 83b) couple the coupling member 822 to the connecting member 821.

A guide mechanism 84 is provided between the connecting member 821 and the coupling member 822. Specifically, the guide mechanism 84 has a linear motion rail 841 provided on one of the connecting member 821 or the coupling member 822 and a linear motion block 842 provided on the other of the connecting member 821 or the coupling member 822.

The plurality of molding dies used in the first and second embodiments described above may be the same molding dies or different molding dies from each other. Here, since the plurality of molding dies may be different from each other, the upper dies may be different from each other and the lower dies may be different from each other.

In the above embodiment, the linear motion rails 71 of the slide mechanism 7 are provided on side wall members 61, 62, and the linear motion blocks 72 are provided on the side surface plate 41, but it is also possible for the linear motion rails 71 of the slide mechanism 7 to be installed on the side surface plate 41 and the linear motion block 72 on the side wall members 61, 62.

Needless to say, the present invention is not limited to the aforementioned embodiments, and various other variations are possible without departing from the intent of the invention.

### Industrial Applicability

According to the present invention configured in this manner, in a resin molding apparatus that clamps a plurality of molding dies, it is possible to, while synchronizing the clamping of the plurality of molding dies, absorb variations in the thickness, etc., of the object-to-be-molded in each molding die and perform resin molding.

### Explanation of Reference Numerals

100: resin molding apparatus
2: fixed platen
3: movable platen
4: intermediate plate
41: side surface plate
5a, 5b, 5c: molding dies
51: upper die
52: lower die
61, 62: side wall members
7: slide mechanism
71: linear motion rail
72: linear motion block
81: pantograph mechanism
811: cross link part
82: coupling mechanism
821: connecting member
822: coupling member
823a, 823b: elastic members
84: guide mechanism
841: linear motion rail
842: linear motion block

## Claims

1. A resin molding apparatus comprising:
a fixed platen;
a movable platen that can be raised and lowered by a drive mechanism;
an intermediate plate arranged between the fixed platen and the movable platen;
molding dies, each including an upper die and a lower die, one of the molding dies being provided between the fixed platen and the intermediate plate and another of the molding dies being provided between the intermediate plate and the movable platen;
a pair of side wall members arranged on both lateral sides of the movable platen and the intermediate plate;
a slide mechanism that causes the intermediate plate to slide with respect to the pair of side wall members; and
a raising-and-lowering linking mechanism that causes the raising and lowering of the intermediate plate to occur together with the raising and lowering of the movable platen; wherein
the raising-and-lowering linking mechanism comprises
a pantograph mechanism that extends and contracts due to the raising and lowering of the movable platen, and
a coupling mechanism that couples a cross link part of the pantograph mechanism and the intermediate plate; and
the coupling mechanism has
a connecting member connected to the cross link part;
a coupling member that couples the connecting member to the intermediate plate; and
an elastic member interposed between the connecting member and the coupling member.

2. The resin molding apparatus according to claim 1, wherein
a plurality of the intermediate plates are arranged along an up-and-down direction between the fixed platen and the movable platen; and
one of said molding dies including the upper die and the lower die is provided between each of the plurality of intermediate plates.

3. The resin molding apparatus according to claim 1 or 2, wherein
the pantograph mechanism is provided on an exterior side of the side wall members;
the coupling member extends to the exterior side of the side wall members; and
the elastic member is provided on the exterior side of the side wall members.

4. The resin molding apparatus according to any one of claims 1 to 3, wherein
the elastic member has a lower side elastic member that absorbs a downward displacement of the intermediate plate relative to the connecting member and an upper side elastic member that absorbs an upward displacement of the intermediate plate relative to the connecting member.

5. The resin molding apparatus according to any one of claims 1 to 4, wherein
the slide mechanism has a linear motion rail and a linear motion block that slides on said linear motion rail.

6. The resin molding apparatus according to claim 5, wherein
a side surface plate is connected to each of both lateral sides of the intermediate plate, the linear motion block is provided on one of the side surface plate or the side wall member, and the linear motion rail is provided on the other of the side surface plate or the side wall member.

7. The resin molding apparatus according to claim 5 or 6, wherein
a side surface plate is connected to each of both lateral sides of the intermediate plate, the linear motion block is provided on the side surface plate, and the linear motion rail is provided on an inner surface of the side wall member.

8. The resin molding apparatus according to claim 7, wherein
two of the linear motion rails are provided on the inner surface of the side wall member, and two rows of the linear motion blocks are provided on the side surface plate corresponding to the two linear motion rails.

9. The resin molding apparatus according to any one of claims 6 to 8, wherein
in a configuration having a plurality of the intermediate plates, the side surface plates respectively connected to the plurality of intermediate plates are displaced in a horizontal direction so as not to interfere with each other.

10. The resin molding apparatus according to any one of claims 1 to 9, further comprising:
a guide mechanism interposed between the connecting member and the coupling member, wherein
the guide mechanism has a linear motion rail provided on one of the connecting member or the coupling member and a linear motion block provided to the other of the connecting member or the coupling member.

11. A resin molded product manufacturing method for manufacturing a resin molded product using the resin molding apparatus according to any one of claims 1 to 10, including:
a resin molding process in which, in a state in which an object-to-be-molded and a resin material have been supplied to the molding dies, the molding dies are clamped and resin molding is performed using the raising-and-lowering linking mechanism, and
a removal process in which the molding dies are opened using the raising-and-lowering linking mechanism and the object-to-be-molded that has been resin molded is removed from the mold.
